# FASCICULE DE BREVET EUROPEEN

(11) **EP 3 600 883 B1**
(45) Date de publication et mention de la délivrance du brevet: **30.08.2023**
(21) Numéro de dépôt: 18718587.1
(22) Date de dépôt: 26.03.2018
(51) Int. Cl.: B32B 17/10

(54) **VITRAGE FEUILLETÉ AVEC EMPILEMENT DE COUCHES**
VERBUNDVERGLASUNG MIT SCHICHTSTAPEL
LAMINATED GLAZING COMPRISING A STACK OF LAYERS

(30) Priorité: 29.03.2017 FR 1752605
(43) Date de publication de la demande: 05.02.2020
(73) Titulaire: SAINT-GOBAIN GLASS FRANCE, 92400 Courbevoie (FR)
(72) Inventeur: COMPOINT, François, 37700 Saint-Pierre-des-Corps (FR); DE GRAZIA, Marco, 92800 Puteaux (FR); DALLE-FERRIER, Cécile, 75010 Paris (FR)
(74) Mandataire: Saint-Gobain Recherche
(86) Numéro de dépôt international: PCT/FR2018/050721
(87) Numéro de publication internationale: WO 2018/178547

(56) Documents cités:
- EP-A2- 1 060 876
- FR-A1- 2 925 483
- FR-A1- 2 999 978
- US-A1- 2008 268 214
- US-A1- 2009 176 101
- DATABASE WPI Week 201703 Thomson Scientific, London, GB; AN 2016-73340X XP002774847, & KR 101 671 192 B1 (RIGMAH GLASS CO LTD) 16 novembre 2016 (2016-11-16)

## Description

La présente invention porte sur un procédé de fabrication d'un vitrage feuilleté dont au moins une des feuilles de verre comprend un empilement de couches minces fonctionnelles, ainsi que sur le vitrage feuilleté susceptible d'être obtenu par ce procédé.

Les vitrages feuilletés sont couramment utilisés dans le domaine de l'automobile, de l'aéronautique ou du bâtiment, puisqu'ils présentent l'avantage d'être des vitrages dits de « sécurité ». Ils sont constitués de deux feuilles de verre liées entre elles par une couche intercalaire thermoplastique. Il est connu d'utiliser des feuilles de verre portant des revêtements fonctionnels conférant aux vitrages des propriétés optiques, thermiques ou électriques. Pour des applications dites de contrôle solaire et/ou de basse émissivité, les revêtements fonctionnels sont à base d'empilement de couches dont certaines sont dites fonctionnelles et d'autres sont dites couches diélectriques. Les couches fonctionnelles, qui sont des couches métalliques, confèrent à l'empilement les propriétés thermiques et/ou optiques recherchées. Les couches dites diélectriques sont généralement en matériaux diélectriques transparents et ont pour rôle essentiel de conférer une protection chimique et/ou mécanique des couches fonctionnelles. Le choix des couches métalliques, des couches de protection, leurs épaisseurs relatives et la façon dont l'empilement est réalisé permet de donner au vitrage certaines propriétés optiques, par exemple en terme de réflexion lumineuse, de transmission lumineuse et de facteur solaire. L'aspect esthétique des substrats revêtus de ces empilements est souvent coloré, la coloration et son intensité dépendant notamment de l'empilement déposé sur le substrat. Pour certaines applications, la coloration obtenue n'est pas celle recherchée et il peut être souhaitable de la neutraliser ou de la modifier légèrement. Le souhait de modifier la coloration existe particulièrement dans les vitrages feuilletés lorsqu'une des feuilles de verre constitutives du vitrage comprend un empilement de couches minces qui donne une certaine teinte qui, lors du procédé de feuilletage, est parfois légèrement modifiée. Dans ce cas précis, les optimisations faites sur l'empilement pour obtenir les propriétés recherchées en terme de couleur ne sont plus valables lorsque l'empilement est positionné sur une feuille de verre constitutive d'un vitrage qui a été feuilleté puisque les traitements thermiques auxquels est soumis le vitrage pendant le procédé de feuilletage font varier la coloration. Pour certaines applications, il peut être nécessaire de devoir développer des empilements spécifiques pour les vitrages feuilletés afin de prévenir la variation de teinte. Or, cette solution est couteuse et compliquée.

FR 2 925 483 A1 décrit un procédé de fabrication d'un vitrage feuilleté comprenant deux feuilles de verre, une feuille intercalaire polymère non colorée, une couche de laque disposée entre les deux feuilles de verre et une couche fonctionnelle. FR 2 999 978 A1 décrit des objets très similaires, mais la couche réfléchissante d'argent (miroir) décrite dans ces documents est nécessairement d'épaisseur bien supérieure à 300 nm, et ces vitrages feuilletés ne sont pas transparents.

On cherche donc à mettre un point un procédé de fabrication de vitrages feuilletés dont au moins une des feuilles de verre constitutives est revêtue d'un revêtement fonctionnel conférant une certaine coloration, qui permette de modifier la coloration de façon simple, en opérant sur des lignes de fabrication de vitrage feuilletés existantes, et dont les coûts de fabrication sont peu élevés. C'est dans ce cadre que s'inscrit la présente invention qui propose un procédé de fabrication permettant de modifier la coloration finale du vitrage feuilleté, tout en gardant la sélectivité du revêtement fonctionnel, et en garantissant des coûts de fabrication bas mais également une très bonne homogénéité de la coloration sur la totalité de la superficie du vitrage, même lorsque celui-ci est de grande taille.

Le procédé selon la présente invention est un procédé de fabrication d'un vitrage feuilleté comprenant au moins deux feuilles de verre, dont au moins une des feuilles de verre a une de ses faces revêtue d'au moins une couche fonctionnelle, les feuilles de verre étant liées entre elles par un intercalaire thermoplastique transparent, non coloré avant l'étape d'assemblage finale du vitrage, et qui se colore pendant la fabrication du vitrage.

Ledit procédé de fabrication du vitrage feuilleté comprenant au moins une première et une deuxième feuille de verre, les deux feuilles étant liées entre elles par un intercalaire thermoplastique, comprend les étapes suivantes :
- dépôt d'un empilement de couches comprenant au moins une couche fonctionnelle sur au moins une face de la première et/ou de la deuxième feuille de verre, ces couches fonctionnelles étant des couches métalliques à base d'argent, d'un alliage comprenant de l'argent, ou d'un métal choisi parmi le niobium, le tantale, le molybdène et/ou le zirconium, et l'épaisseur du revêtement fonctionnel étant inférieure à 300 nm,
- dépôt par voie liquide, sur au moins une face de la première et/ou de la deuxième feuille de verre, d'une couche polymérique comprenant une anthraquinone comme agent colorant et des composés (méth)acrylates comme composés polymériques, les composés polymériques utilisés dans la couche polymérique étant chimiquement compatibles avec l'intercalaire thermoplastique, la composition polymérique comprenant au moins un oligomère uréthane-acrylique, au moins un monomère (méth)acrylate mono-, bi- ou tri-fonctionnel, au moins un initiateur de polymérisation et au moins un agent colorant dissout dans la composition polymérique et représentant entre 0,01 et 10 % en masse par rapport à la masse totale des composés polymériques,
- séchage et éventuellement durcissement de la couche polymérique,
- assemblage de la feuille de verre revêtue de la couche polymérique colorée avec un intercalaire thermoplastique transparent non coloré, et avec l'autre feuille de verre, de telle sorte que la couche polymérique colorée soit en contact direct avec ledit intercalaire,
- dégazage pendant lequel l'air piégé entre les feuilles de verre et l'intercalaire thermoplastique est éliminé, et
   - traitement thermique sous pression et/ou sous vide du verre feuilleté à une température comprise entre 100 et 200°C pendant lequel l'agent colorant présent dans la couche polymérique migre vers l'intercalaire thermoplastique et pendant lequel l'assemblage du vitrage feuilleté est effectué, et
- l'intercalaire thermoplastique est du polyvinyle butyral, du polyéthylène, de l'éthylène-acétate de vinyle.

De façon avantageuse, le procédé selon la présente invention permet de modifier la coloration d'un vitrage feuilleté, grâce à la migration de l'agent colorant qui s'effectue depuis la couche polymérique colorée vers l'intercalaire thermoplastique pendant le procédé de fabrication du vitrage feuilleté. La modification de la coloration est apportée par la présence d'une couche polymérique, facile à appliquer par voie liquide et peu coûteuse, sur au moins une des faces internes d'une des feuilles de verre constitutives du vitrage feuilleté. Lors du procédé de fabrication du vitrage, et en particulier pendant l'assemblage des différentes parties constitutives du vitrage, un phénomène de migration de l'agent colorant se produit de façon uniforme sur la totalité de l'épaisseur de l'intercalaire polymérique. L'homogénéité de la coloration est ainsi garantie, même sur des substrats de grande taille, à partir d'un procédé simple à mettre en oeuvre ne demandant pas de modifier les étapes classiques des procédés de fabrication d'un vitrage feuilleté (assemblage des différentes parties, dégazage et traitement thermique en vue du collage final). De façon surprenante, ce procédé permet d'obtenir des vitrages feuilletés d'une coloration homogène, sans nécessiter une qualité dite « optique » de la couche polymérique teintée. La phase d'assemblage et de traitement thermique corrige les imperfections de coloration qui peuvent éventuellement exister dans la couche polymérique colorée. Ainsi, le procédé selon l'invention permet de neutraliser ou de modifier simplement la coloration induite par l'empilement de couches minces, sans qu'il y ait besoin de modifier ledit empilement de façon à anticiper les modifications de teintes dues aux traitements thermiques réalisés pendant le procédé d'assemblage.

Au sens de la présente invention, on comprend par « face interne » d'une feuille de verre la face de la feuille qui se retrouve, après assemblage, en contact avec l'intercalaire thermoplastique. Les faces internes dans un vitrage feuilleté comprenant deux feuilles de verre sont souvent appelées face 2 et face 3, la face 2 appartenant à la première feuille de verre et la face 3 à la deuxième feuille de verre. Dans le procédé selon la présente invention, les faces internes (ou encore face 2 ou 3) sont celles sur lesquelles est déposée la couche polymérique. Cette couche peut être déposée sur une face d'une des deux feuilles de verre constituant le vitrage feuilleté ou sur une face de chacune des feuilles de verre constituant le vitrage feuilleté.

L'empilement de couches minces est déposé sur la première et/ou la deuxième feuille de verre constitutive du vitrage feuilleté. Préférentiellement, le dépôt consistant à déposer sur un substrat transparent une ou plusieurs couches fonctionnelles est effectué sur les faces des feuilles de verre qui, après assemblage, constitueront les faces internes (face 2 et/ou face 3) du vitrage feuilleté. La couche fonctionnelle est par exemple une couche pouvant agir sur le rayonnement solaire et/ou le rayonnement infrarouge de grande longueur d'onde. Ces couches fonctionnelles sont des couches métalliques à base d'argent, d'un alliage comprenant de l'argent ou d'un métal choisi parmi le niobium, le tantale, le molybdène et/ou le zirconium. La feuille de verre sur laquelle est déposé le revêtement fonctionnel peut comprendre un empilement de couches minces comportant successivement une alternance de n couches métalliques fonctionnelles et de (n+1) revêtements antireflets, chaque revêtement antireflet comportant au moins une couche diélectrique, de sorte à ce que chaque couche métallique fonctionnelle soit disposée entre deux revêtements antireflets. De préférence, n vaut 1, 2, 3 ou 4. De façon encore plus préférée, n est supérieur à 1, notamment n vaut 2 ou 3. Les couches diélectriques sont également déposées par pulvérisation cathodique assistée par champ magnétique. Ces couches de diélectriques sont par exemple choisies parmi les oxydes, les nitrures ou oxy-nitrures d'un ou plusieurs éléments choisi (s) parmi le titane, le silicium, l'aluminium, le zirconium, le hafnium, l'étain et le zinc.

Un exemple d'empilement pouvant être déposé comprend :
- un revêtement diélectrique situé en-dessous du revêtement fonctionnel,
- un revêtement fonctionnel,
- un revêtement diélectrique situé au-dessus du revêtement fonctionnel,
- éventuellement une couche de protection.

L'épaisseur du revêtement fonctionnel est inférieure à 300 nm, généralement supérieure à 100 nm, de préférence supérieure à 150 nm et de préférence inférieure à 250 nm.

Le revêtement fonctionnel peut être déposé par tout moyen connu tel que par pulvérisation cathodique assistée par un champ magnétique, par évaporation thermique, par CVD ou PECVD, par pyrolyse, par dépôt par voir chimique, par voie de type sol-gel ou dépôt de couches inorganiques par voie humide. De préférence, dans le procédé selon l'invention, le revêtement fonctionnel est déposé par pulvérisation cathodique assistée par un champ magnétique. Selon ce mode de réalisation avantageux, toutes les couches du revêtement fonctionnel sont déposées par pulvérisation cathodique assistée par un champ magnétique.

L'empilement fonctionnel est notamment caractérisé par des mesures de propriétés optiques telles que la transmission lumineuse TL, la réflexion lumineuse extérieure et/ou intérieure, les composantes colorimétriques a* et b* du modèle CIE Lab de représentation des couleurs développé par la Commission Internationale de l'Eclairage, et les performances de contrôle solaire, telles que le facteur solaire et la sélectivité. Le facteur solaire, noté « g », est le rapport entre l'énergie totale traversant le vitrage et l'énergie solaire incidente. La sélectivité, notée « s », est le rapport entre la transmission lumineuse et le facteur solaire.

La couche polymérique est une couche applicable par voie liquide. Le polymère peut être dissous dans un solvant pour rendre le dépôt par voie liquide possible. On peut citer par exemple une couche polymérique à base de polyvinyle butyral, de polyéthylène, de l'éthylène-acétate de vinyle dissous dans un solvant. Tout autre matériau polymérique chimiquement compatible avec l'intercalaire thermoplastique placé entre les deux feuilles de verre peut être utilisé. De préférence, dans l'objectif d'utiliser des formulations de polymères avec le moins de solvant possible pour des aspects EHS, la couche polymérique colorée est de préférence une couche obtenue à partir d'une composition comprenant des composés époxyde ou des composés méthacrylate. La couche polymérique est obtenue à partir d'une composition liquide comprenant au moins un oligomère uréthane-acrylique aliphatique, au moins un monomère (méth)acrylate mono, bi ou tri-fonctionnel, au moins un initiateur de polymérisation et au moins un agent colorant. De façon préférée, le monomère (méth)acrylate est mono- ou bi-fonctionnel et donc il comporte au plus deux sites réactifs. La fonctionnalité relativement basse des monomères utilisés pour polymériser la couche polymérique facilite la migration de l'agent colorant au sein de la couche.

La composition liquide comprend avantageusement en pourcentage massique par rapport à la masse totale des composés (méth)acrylates, de 30 à 80% en masse d'au moins un oligomère uréthane-acrylique aliphatique et de 20 à 70% en masse d'au moins un monomère (méth)acrylate mono ou bi-fonctionnel. L'agent colorant représente entre 0,01 et 10% en masse par rapport à la masse totale des composés polymériques. L'agent colorant est une anthraquinone. Il est inséré dans la composition polymérique à l'état moléculaire, c'est-à-dire qu'il est dissout dans la composition et ne forme pas de particules solides. De façon très avantageuse, le colorant possède des propriétés acido-basiques permettant d'augmenter son affinité avec l'intercalaire thermoplastique. Ainsi à titre d'exemple, le colorant est un composé organique de type acide de Lewis, et l'intercalaire thermoplastique est une base, ce qui permet de favoriser la migration du colorant depuis la couche polymérique vers l'intercalaire thermoplastique. On peut citer comme colorant les dérivés de la famille des anthraquinones (Acid Blue 25, Alizarin, Anthrapurpurin, Carminic acid, 1,4-Diamino-2,3-dihydroanthraquinone, 7,14-Dibenzpyrenequinone, Dibromoanthanthrone, 1,3-Dihydroxyanthraquinone, 1,4-Dihydroxyanthraquinone, Disperse Red 9, Disperse Red 11, Indanthrone blue, Morindone, Oil Blue 35, Oil Blue A, Parietin, Quinizarine Green SS, Remazol Brilliant Blue R, Solvent Violet 13, 1,2,4-Trihydroxyanthraquinone, Vat Orange 1, Vat Yellow 1).

La couche polymérique peut comprendre dans sa composition un agent promoteur d'adhésion, comme par exemple un silane ou tout autre composé promoteur d'adhésion à base d'un métal comme le titane, le zirconium, l'étain ou l'aluminium.

Le dépôt de la couche polymérique est effectué, sur une face d'au moins une des feuilles de verre, par application à température ambiante de ladite composition liquide, par enduction au rouleau, par aspersion, par trempage, par enduction au rideau ou par pulvérisation. De préférence, l'application de la composition liquide est effectuée par enduction au rouleau ou au rideau.

La couche polymérique est déposée sur au moins une des faces 2 ou 3 des feuilles de verre, c'est-à-dire sur une des faces qui sont en contact avec l'intercalaire thermoplastique. La couche polymérique peut être déposée sur le revêtement fonctionnel.

Après avoir été déposée sur une des faces d'au moins une feuille de verre, la couche polymérique est séchée et/ou durcie à une température inférieure à 200°C. Si la couche polymérique déposée contient un solvant, ce dernier va être évaporé lors de l'étape de séchage. La couche polymérique peut également être durcie lors de cette étape qui entraîne une cuisson/réticulation par exemple par UV, ou par faisceau d'électrons.

L'épaisseur de la couche polymérique durcie est comprise entre 1 et 200 µm.

L'étape de dépôt de la couche polymérique peut être effectuée directement sur la ligne de fabrication de vitrage feuilleté et constitue alors la première étape lors de la fabrication en usine du vitrage feuilleté. L'étape de dépôt peut également être effectuée sur une autre ligne de fabrication que celle du vitrage feuilleté. Dans ce cas, la ou les feuilles de verre revêtues de la couche de polymère arrivent sur la ligne d'assemblage des vitrages feuilletés avec le revêtement polymérique séché et/ou durci.

La feuille de verre ainsi revêtue de la couche polymérique est ensuite assemblée avec l'intercalaire thermoplastique et avec une deuxième feuille de verre pour faire le vitrage feuilleté. La deuxième feuille de verre peut également comprendre sur la face destinée à être la face interne une couche polymérique identique à celle déposée sur la première feuille de verre, ou une couche polymérique légèrement différente, notamment en termes de coloration.

Selon un mode de réalisation, une première feuille de verre comprenant sur sa face 2 le revêtement fonctionnel et la couche polymérique est assemblée avec l'intercalaire thermoplastique transparent et une seconde feuille de verre. Cette seconde feuille de verre peut éventuellement comprendre sur sa face 3 une couche polymérique et/ou un revêtement fonctionnel.

Selon un autre mode de réalisation, une première feuille de verre comprenant sur sa face 2 le revêtement fonctionnel est assemblée avec l'intercalaire thermoplastique et avec une seconde feuille de verre sur laquelle a été déposée la couche polymérique. Cette seconde feuille de verre peut éventuellement comprendre un revêtement fonctionnel.

Afin d'améliorer l'adhésion entre les différents éléments constituant le vitrage feuilleté, à savoir entre les feuilles de verre et l'intercalaire thermoplastique, le procédé selon l'invention peut comprendre une étape de traitement de la surface de la feuille de verre sur laquelle est déposée la couche polymérique colorée et/ou de la surface de la face de l'intercalaire thermoplastique en contact avec la couche polymérique par un agent promoteur d'adhésion.

L'intercalaire thermoplastique est du polyvinyle butyral, du polyéthylène, de l'éthylène-acétate de vinyle, ou tout autre matériau thermoplastique. L'intercalaire peut être composé de plusieurs couches associées entre elles, la sous-couche en contact avec la couche polymérique étant une sous-couche de nature organique.

Le procédé selon l'invention permet avantageusement de préparer des verres feuilletés colorés sans nécessiter de modification des phases d'assemblage du vitrage feuilleté. A partir du moment où la ou les feuilles de verre constitutives du vitrage feuilleté sont revêtues de la couche polymérique colorée, elles sont assemblées avec l'intercalaire thermoplastique de façon usuelle par un traitement thermique à une température comprise entre 100 et 200°C, sous vide et/ou sous pression. Ce traitement thermique peut par exemple être effectué dans un autoclave à une température comprise entre 135 et 145°C, sous une pression comprise entre 5 et 14 bars.

L'invention porte également sur un vitrage feuilleté susceptible d'être obtenu par le procédé décrit ci-avant. Ce vitrage peut être utilisé dans le domaine du bâtiment, à usage décoratif notamment, ou bien en tant que vitrage automobile. Les vitrages feuilletés obtenus possèdent la résistance mécanique souhaitée pour ce type d'application et peuvent être considérés comme des vitrages de sécurité.

L'exemple suivant illustre l'invention sans en limiter la portée.

Deux feuilles de verre plan d'environ 6 mm d'épaisseur, obtenues par un procédé de flottage (encore connu sou le terme anglais de « float ») sont utilisées pour fabriquer un vitrage feuilleté selon la présente invention.

Un revêtement fonctionnel comprenant l'empilement de couches minces déposées par un dispositif de pulvérisation cathodique assistée par champ magnétique (magnétron) est déposé sur une face d'une première feuille de verre. L'empilement de couches minces comporte successivement à partir de la feuille de verre une alternance de trois revêtements diélectriques et de deux couches d'argent (couches métalliques fonctionnelles), chaque revêtement diélectrique comportant au moins une couche diélectrique, de manière à ce que chaque couche métallique fonctionnelle soit disposée entre deux revêtements diélectriques. La couche du revêtement fonctionnel la plus éloignée de la feuille de verre est une couche de nitrure de titane et de zirconium de 1 à 5 nm. L'épaisseur totale de ce revêtement fonctionnel est comprise entre 150 et 200 nm.

Une composition liquide comprenant un oligomère acrylate de type Sartomer CN9002 (oligomère uréthane-acrylate aliphatique bi-fonctionnel), CN131B (monomère monoacrylate aromatique), SR610 (oligomère acrylate polyéthylène glycol) et de monomère SR 410 (monomère acrylique aromatique monofonctionel) est préparée avec un ratio pondéral 50/50. Un colorant de type anthraquinone est ajouté à la formulation d'acrylate, dans une quantité de 0,13 % en poids par rapport au poids total de la composition d'acrylate liquide. 5 % en poids d'un photo-initiateur de type Speedcure 500 est ajouté au mélange précédent de sorte à permettre le démarrage de la polymérisation. La composition liquide ainsi obtenue est déposée par voie liquide par enduction au tire film mécanique sur l'empilement de couches fonctionnelles, décrit ci-avant. La couche polymérique humide a une épaisseur de 30 µm. Elle est durcie par irradiation UV. L'épaisseur de la couche colorée sèche est d'environ 20 µm.

Un intercalaire en PVB non coloré est posé sur la couche polymérique colorée et la deuxième feuille de verre est posée sur l'intercalaire de façon à refermer le vitrage feuilleté. L'ensemble est placé sous autoclave pendant 45 minutes, à 140°C sous une pression de 10 bars.

A la sortie de l'autoclave, on obtient un verre feuilleté transparent où la couleur de l'empilement de couches a été modifié.

Les caractéristiques optiques et colorimétriques d'un vitrage feuilleté sans couche polymérique (référence) et du vitrage feuilleté avec la couche polymérique tel qu'obtenu précédemment sont données dans le tableau ci-dessous.

La transmission lumineuse est TL est donnée en % et est mesurée selon l'illuminant D65 à 2° observateur. Les coordonnées a*T et b*T indiquent les couleurs en transmission a* et b* dans le système L*a*b* mesurées selon l'illuminant D65 à 2°observateur, perpendiculairement au vitrage. La réflexion lumineuse extérieure correspond à la réflexion lumineuse dans le visible, donnée en pourcentage et mesurée selon l'illuminant D65 à 2°observateur, du côté de la face la plus à l'extérieur, c'est à dire la face 1 puisque l'empilement est positionné en face 2. Les coordonnées colorimétriques a*R et b*R indiquent les couleurs en réflexion a* et b* dans le système L*a*b* mesurées selon l'illuminant D65 à 2° observateur, mesurées perpendiculairement au vitrage. On notera a*Rext et b*Rext les couleurs mesurées du côté de la face la plus extérieure et a*Rint et b*Rint les couleurs mesurées sur la face la plus intérieure, c'est-à-dire la face 4 puisque l'empilement est positionné en face 2.

| | **g** | **TL** | **a^{∗}T** | **b^{∗}T** | **Rext** | **a^{∗}ext** | **b^{∗}ext** | **Rint** | **a^{∗}int** | **b^{∗}int** | **Sélectivité** |
|---|---|---|---|---|---|---|---|---|---|---|---|
| Empilement seul | 31.5 | 51,2 | **-12** | -0,1 | 25,6 | 14,6 | **-6,4** | 18,4 | -5,5 | -20,2 | 1,6 |
| Empilement avec la couche polymérique | 30.6 | 45,5 | **-7,3** | 0,3 | 21,8 | 17,4 | **-1,3** | 18,4 | -5,5 | -20 | 1,5 |

Sur le vitrage selon l'invention, c'est-à-dire avec la couche polymérique, les modifications de coloration sont notables en termes de a*T (niveau sur l'axe vert-rouge en lumière transmise) et b*ext (niveau sur l'axe bleu-jaune en lumière réfléchie extérieure) tout en gardant une bonne capacité d'absorption sélective (sélectivité) des IR et une transmission proche de 50%.

## Revendications

1. Procédé de fabrication d'un vitrage feuilleté coloré comprenant au moins une première et une deuxième feuille de verre, les deux feuilles étant liées entre elles par un intercalaire thermoplastique **caractérisé en ce qu'**il comprend les étapes suivantes :
- dépôt d'un empilement de couches comprenant au moins une couche fonctionnelle sur au moins une face de la première et/ou de la deuxième feuille de verre, ces couches fonctionnelles étant des couches métalliques à base d'argent, d'un alliage comprenant de l'argent, ou d'un métal choisi parmi le niobium, le tantale, le molybdène et/ou le zirconium, et l'épaisseur du revêtement fonctionnel étant inférieure à 300 nm,
- dépôt par voie liquide sur au moins une face de la première et/ou de la deuxième feuille de verre d'une couche polymérique comprenant une anthraquinone comme agent colorant et des composés (méth)acrylates comme composés polymériques, les composés polymériques utilisés dans la couche polymérique étant chimiquement compatibles avec l'intercalaire thermoplastique, la composition polymérique comprenant au moins un oligomère uréthane-acrylique, au moins un monomère (méth)acrylate mono-, bi- ou tri-fonctionnel, au moins un initiateur de polymérisation et au moins un agent colorant dissout dans la composition polymérique et représentant entre 0,01 et 10 % en masse par rapport à la masse totale des composés polymériques,
- séchage et éventuellement durcissement de la couche polymérique,
- assemblage de la feuille de verre revêtue de la couche polymérique colorée avec un intercalaire thermoplastique transparent non coloré, et avec la deuxième feuille de verre, de telle sorte que la couche polymérique colorée soit en contact direct avec ledit intercalaire,
- dégazage pendant lequel l'air piégé entre les feuilles de verre et l'intercalaire thermoplastique est éliminé, et
- traitement thermique sous pression et/ou sous vide du verre feuilleté à une température comprise entre 100 et 200°C pendant lequel l'agent colorant présent dans la couche polymérique migre vers l'intercalaire thermoplastique et pendant lequel l'assemblage du vitrage feuilleté est effectué, et
**en ce que** l'intercalaire thermoplastique est du polyvinyle butyral, du polyéthylène, de l'éthylène-acétate de vinyle.

2. Procédé selon la revendication précédente **caractérisé en ce que** le dépôt de l'empilement de couches est effectué par pulvérisation cathodique assistée par champ magnétique.

3. Procédé selon l'une des revendications précédentes **caractérisé en ce que** le dépôt de la couche polymérique est effectué sur l'empilement fonctionnel.

4. Procédé selon l'une des revendications précédentes **caractérisé en ce que** la couche polymérique colorée est une couche obtenue par durcissement d'une composition comprenant des composés époxyde ou des composés méthacrylate.

5. Procédé selon la revendication 1 **caractérisé en ce que** la couche polymérique est obtenue à partir d'une composition liquide qui comprend en pourcentage massique par rapport à la masse totale des composés (méth)acrylates, de 30 à 80% en masse d'au moins un oligomère uréthane-acrylique aliphatique et de 20 à 70% en masse d'au moins un monomère (méth)acrylate mono ou bi-fonctionnel.

6. Procédé selon l'une des revendications précédentes **caractérisé en ce que** la couche polymérique comprend un agent promoteur d'adhésion.

7. Procédé selon l'une des revendications précédentes **caractérisé en ce que** le dépôt de la couche polymérique est effectué par application à température ambiante de ladite composition liquide, par enduction au rouleau, par aspersion, par trempage, par enduction au rideau ou par pulvérisation.

8. Procédé selon la revendication précédente **caractérisé en ce que** l'application de la composition liquide est effectuée par enduction au rouleau ou au rideau.

9. Procédé selon l'une des revendications précédentes **caractérisé en ce que** la couche polymérique est durcie par séchage à une température inférieure à 200°C, par réticulation UV, ou par faisceau d'électrons.

10. Procédé selon l'une des revendications précédentes **caractérisé en ce que** l'épaisseur de la couche polymérique durcie est comprise entre 1 et 200 µm.

11. Procédé selon l'une des revendications précédentes **caractérisé en ce qu'**il comprend une étape de traitement de la surface de la feuille de verre sur laquelle est déposée la couche polymérique colorée et/ou de la surface de la face de l'intercalaire thermoplastique en contact avec la couche polymérique par un agent promoteur d'adhésion.

12. Procédé selon la revendication 1, **caractérisé en ce que** l'épaisseur du revêtement fonctionnel est supérieure à 100 nm.

13. Vitrage feuilleté susceptible d'être obtenu par le procédé selon l'une des revendications précédentes.

## Patentansprüche

1. Verfahren zum Herstellen einer farbigen Verbundverglasung, die mindestens eine erste und eine zweite Glasscheibe umfasst, wobei die zwei Scheiben durch eine thermoplastische Zwischenlage miteinander verbunden sind, **dadurch gekennzeichnet, dass** es folgende Schritte umfasst:
- Aufbringen einer Stapelung von Schichten, die mindestens eine funktionelle Schicht auf mindestens einer Seite der ersten und/oder der zweiten Glasscheibe umfasst, wobei diese funktionellen Schichten Metallschichten auf Basis von Silber, einer Silber umfassenden Legierung oder eines aus Niob, Tantal, Molybdän und/oder Zirkonium ausgewählten Metalls sind und die Dicke der funktionellen Beschichtung weniger als 300 nm beträgt,
- Aufbringen auf flüssigem Wege auf mindestens einer Seite der ersten und/oder der zweiten Glasscheibe einer Polymerschicht, die ein Anthrachinon als Färbemittel und (Meth)acrylatverbindungen als Polymerverbindungen umfasst, wobei die in der Polymerschicht verwendeten Polymerverbindungen mit der thermoplastischen Zwischenlage chemisch verträglich sind, die Polymerzusammensetzung mindestens ein Urethan-Acryl-Oligomer, mindestens ein mono-, bi- oder trifunktionelles (Meth)acrylat-Monomer, mindestens einen Polymerisationsinitiator und mindestens ein Färbemittel umfasst, das in der Polymerzusammensetzung gelöst ist und zwischen 0,01 und 10 Gew.-%, bezogen auf das Gesamtgewicht der Polymerverbindungen, ausmacht,
- Trocknen und optional Härten der Polymerschicht,
- Zusammenfügen der mit der farbigen Polymerschicht beschichteten Glasscheibe mit einer transparenten, nicht farbigen thermoplastischen Zwischenlage und mit der zweiten Glasscheibe, so dass die farbige Polymerschicht in direktem Kontakt mit der Zwischenlage ist,
- Entgasen, während dem die zwischen den Glasscheiben und der thermoplastischen Zwischenlage eingeschlossene Luft entfernt wird, und
- Wärmebehandeln des Verbundglases unter Druck und/oder Vakuum bei einer Temperatur zwischen 100 und 200 °C, während dem das in der Polymerschicht vorhandene Färbemittel in Richtung der thermoplastischen Zwischenlage migriert und während dem das Zusammenfügen der Verbundverglasung erfolgt, und
**dass** die thermoplastische Zwischenlage Polyvinylbutyral, Polyethylen und Ethylenvinylacetat ist.

2. Verfahren nach einem der vorstehenden Ansprüche,
**dadurch gekennzeichnet, dass** das Aufbringen der Stapelung von Schichten durch magnetfeldunterstützte Kathodenzerstäubung erfolgt.

3. Verfahren nach einem der vorstehenden Ansprüche,
**dadurch gekennzeichnet, dass** das Aufbringen der Polymerschicht auf der funktionellen Stapelung erfolgt.

4. Verfahren nach einem der vorstehenden Ansprüche,
**dadurch gekennzeichnet, dass** die farbige Polymerschicht eine Schicht ist, die durch Härten einer Zusammensetzung erhalten wird, die Epoxidverbindungen oder Methacrylatverbindungen enthält.

5. Verfahren nach Anspruch 1, **dadurch gekennzeichnet, dass** die Polymerschicht ausgehend von einer flüssigen Zusammensetzung erhalten wird, die in Masseprozent, bezogen auf die Gesamtmasse der (Meth)acrylatverbindungen, zu 30 bis 80 Masse-% mindestens ein aliphatisches Urethan-Acryl-Oligomer und zu 20 bis 70 Masse-% mindestens ein mono- oder bifunktionelles (Meth)acrylat-Monomer umfasst.

6. Verfahren nach einem der vorstehenden Ansprüche,
**dadurch gekennzeichnet, dass** die Polymerschicht einen Haftvermittler umfasst.

7. Verfahren nach einem der vorstehenden Ansprüche,
**dadurch gekennzeichnet, dass** das Aufbringen der Polymerschicht durch Auftragen der flüssigen Zusammensetzung bei Raumtemperatur durch Walzenbeschichtung, durch Berieselung, durch Eintauchen, durch Vorhangbeschichtung oder durch Zerstäuben erfolgt.

8. Verfahren nach dem vorstehendem Anspruch,
**dadurch gekennzeichnet, dass** das Auftragen der flüssigen Zusammensetzung durch Walzen- oder Vorhangbeschichtung erfolgt.

9. Verfahren nach einem der vorstehenden Ansprüche,
**dadurch gekennzeichnet, dass** die Polymerschicht durch Trocknen bei einer Temperatur unterhalb von 200 °C, durch UV-Vernetzung oder durch einen Elektronenstrahl gehärtet wird.

10. Verfahren nach einem der vorstehenden Ansprüche,
**dadurch gekennzeichnet, dass** die Dicke der gehärteten Polymerschicht zwischen 1 und 200 µm beträgt.

11. Verfahren nach einem der vorstehenden Ansprüche,
**dadurch gekennzeichnet, dass** es einen Behandlungsschritt der Oberfläche der Glasscheibe, auf der die farbige Polymerschicht aufgebracht wird, und/oder der Oberfläche der Seite der thermoplastischen Zwischenlage, die mit der Polymerschicht in Kontakt ist, mit einem Haftvermittler umfasst.

12. Verfahren nach Anspruch 1, **dadurch gekennzeichnet, dass** die Dicke der funktionellen Beschichtung größer als 100 nm ist.

13. Verbundverglasung, die durch das Verfahren nach einem der vorstehenden Ansprüche erhalten werden kann.

## Claims

1. Method for manufacturing a colored laminated glazing comprising at least a first glass sheet and a second glass sheet, the two sheets being connected to one another by a thermoplastic interlayer, **characterized in that** it comprises the following steps:
- depositing a stack of layers comprising at least one functional layer on at least one face of the first and/or second glass sheet, said functional layers being metal layers based on silver, on an alloy comprising silver, or on a metal selected from niobium, tantalum, molybdenum and/or zirconium, and the thickness of the functional coating being less than 300 nm,
- depositing, in liquid form, a polymeric layer comprising an anthraquinone as a coloring agent and (meth)acrylate compounds as polymeric compounds on at least one face of the first and/or second glass sheet, the polymeric compounds used in the polymeric layer being chemically compatible with the thermoplastic interlayer, the polymeric composition comprising at least one urethane-acrylic oligomer, at least one mono-, bi- or trifunctional (meth)acrylate monomer, at least one polymerization initiator and at least one coloring agent which is dissolved in the polymeric composition and represents between 0.01 and 10% by weight with respect to the total weight of the polymeric compounds,
- drying and optionally curing the polymeric layer,
- assembling the glass sheet coated with the colored polymeric layer with a colorless transparent thermoplastic interlayer, and with the second glass sheet, so that the colored polymeric layer is in direct contact with said interlayer,
- degassing, during which the air trapped between the glass sheets and the thermoplastic interlayer is removed, and
- performing a heat treatment of the laminated glass under pressure and/or under vacuum at a temperature of between 100 and 200°C, during which the coloring agent present in the polymeric layer migrates toward the thermoplastic interlayer and during which the laminated glazing is assembled, and
**and in that** the thermoplastic interlayer is polyvinyl butyral, polyethylene or ethylene-vinyl acetate.

2. Method according to the preceding claim, **characterized in that** the stack of layers is deposited by magnetic-field-assisted cathode sputtering.

3. Method according to either of the preceding claims, **characterized in that** the polymeric layer is deposited on the functional stack.

4. Method according to one of the preceding claims, **characterized in that** the colored polymeric layer is a layer obtained by curing a composition comprising epoxide compounds or methacrylate compounds.

5. Method according to claim 1, **characterized in that** the polymeric layer is obtained using a liquid composition comprising, as percentage by weight with respect to the total weight of the (meth)acrylate compounds, from 30% to 80% by weight of at least one aliphatic urethane-acrylic oligomer and from 20% to 70% by weight of at least one mono- or bifunctional (meth)acrylate monomer.

6. Method according to one of the preceding claims, **characterized in that** the polymeric layer comprises an adhesion-promoting agent.

7. Method according to one of the preceding claims, **characterized in that** the polymeric layer is deposited by application at ambient temperature of said liquid composition, by roll coating, by sprinkling, by dipping, by curtain coating or by spraying.

8. Method according to the preceding claim, **characterized in that** the liquid composition is applied by roll coating or by curtain coating.

9. Method according to one of the preceding claims, **characterized in that** the polymeric layer is cured by drying at a temperature of less than 200°C, by UV crosslinking or by an electron beam.

10. Method according to one of the preceding claims, **characterized in that** the thickness of the cured polymeric layer is between 1 and 200 µm.

11. Method according to one of the preceding claims, **characterized in that** it comprises a step of treating, by an adhesion-promoting agent, the surface of the glass sheet on which the colored polymeric layer is deposited and/or of treating the surface of the face of the thermoplastic interlayer that is in contact with the polymeric layer.

12. Method according to claim 1, **characterized in that** the thickness of the functional coating is greater than 100 nm.

13. Laminated glazing which can be obtained by the method according to one of the preceding claims.
